(19) Europäisches Patentamt

European Patent Office

Office européen des brevets

(11) EP 1 498 780 A2

(12) EUROPEAN PATENT APPLICATION

(43) Date of publication:
19.01.2005 Bulletin 2005/03

(51) Int Cl.⁷: G03F 7/20

(21) Application number: 04077030.7

(22) Date of filing: 13.07.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 15.07.2003 EP 03077222

(71) Applicant: ASML Netherlands B.V.
5504 DR Veldhoven (NL)

(72) Inventors:
• Ottens, Joost Jeroen
5508 TR Veldhoven (NL)

• Van Empel, Tjarko Adriaan Rudolf
5643 SC Eindhoven (NL)
• Zaal, Koen Jacobus Johannes Maria
5611 JB Eindhoven (NL)

(74) Representative:
Winckels, Johannes Hubertus F. et al
Vereenigde
Nieuwe Parklaan 97
2587 BN Den Haag (NL)

(54) **Substrate holder and lithographic projection apparatus**

(57)  A lithographic projection apparatus comprising: a radiation system (IL) for providing a projection (PB) beam of radiation; a support structure (MT) for supporting patterning means (MA), the patterning means serving to pattern the projection beam according to a desired pattern; a substrate holder (1) comprising a plurality of protrusions (2) defining a protrusion configuration for providing a substantially flat plane of support for supporting a substantially flat substrate, the substrate holder (1) comprising at least one clamping electrode (8) for generating an electric field, for clamping a substrate against the substrate holder (1) by said electric field; the substrate holder (1) further comprising a peripheral supporting edge (3) arranged to contact a substrate; and a projection system (PL) for projecting the patterned beam onto a target portion of the substrate. According to the invention, the said at least one electrode (8) extends beyond said peripheral supporting edge.

Figure 2

**Description**

The present invention relates to a lithographic projection apparatus comprising: a radiation system for providing a projection beam of radiation; and a substrate holder for supporting a substrate to be placed in a beam path of said projection beam, comprising a plurality of protrusions defining a protrusion configuration for providing a substantially flat plane of support for supporting a substantially flat substrate, the substrate holder comprising at least one clamping electrode for generating an electric field, for clamping the substrate against the substrate holder by said electric field; the substrate holder further comprising a peripheral supporting edge arranged to contact a substrate.

Known electrostatic clamps are usually provided with means for using a backfill gas, which is used to fill the spaces formed between the protrusions, a base plate that forms a ground layer for supporting the protrusions and the backside of a substrate clamped by the substrate holder. Such a backfill gas enhances the heat transfer capability from the substrate to the substrate holder. In order not to spill this backfill gas in vacuum operating conditions, the clamping pressure should be larger than the backfill gas pressure and in order to provide a leak-tight confinement, a wall is present having a contour that generally follows the contour of the substrate and which provides, when the substrate contacts the substrate holder, a gas-tight environment.

European patent application EP0947884 describes a lithographic apparatus having a substrate holder wherein protrusions are arranged to improve the flatness of the substrate. These protrusions have a general diameter of 0.5 mm and are located generally at a distance of 3 mm away from each other and thereby form a bed of supporting members that support the substrate. A typical height of the protrusions is 5 μm. However, for electrostatic clamping configurations, especially for electrostatic clamping configurations where a hard rim is present for confining a backfill gas to the back of a substrate to be irradiated, the wafer tends to be supported unevenly, especially near the boundary of the protrusion configuration, due to the termination of support near the boundary edge. This may cause, depending on the degree of overhang, an upward lifting of the wafer or a downward "sagging" near the edges, which may result in unacceptable imaging quality.

The invention has as one of its objects to provide a photolithographic apparatus according to the preamble, wherein the problem of unevenness of the wafer support near the boundary of the substrate holder is addressed and wherein a substrate is leveled in a controllable way near the edges of the substrate.

In order to achieve said object, the photolithographic apparatus of the invention is arranged according to the characterizing features of claim 1.

By extending the clamping electrode beyond said the last supporting edge of the substrate holder, in a controllable way, the clamping pressure near the boundaries of the substrate can be varied. Thus, depending on the size of the substrate in relation to the size of the support defined by the protrusion configuration, the electrode can be extended outside the peripheral edge in order to provide an optimum downward torsion moment for the substrate near the edges. In a preferred embodiment, said protrusion configuration is arranged in a series of concentric circles, the circles being mutually separated over a distance $a$, and wherein the electrode extension generates a torsion load that ranges from 0.1 and 3 times a reference torsion load defined by $M = \frac{1}{12} \Delta p a^2$, wherein $\Delta p$ is an applied clamping pressure. In such a range, it can be shown, that the bending moments introduce optimal height differences of the substrate near the supporting edge.

In an embodiment wherein said protrusion configuration is arranged in a series of concentric circles, said electrode extension preferably satisfies the relationship of $0.3 < b/a < 0.4$, wherein $b$ is the distance of the electrode extension and $a$ the mutual separation between two concentric circles nearest the peripheral supporting edge.

In a further preferred embodiment, said substrate holder comprises a ground electrode extending around the peripheral supporting edge. By such a ground electrode, the electrostatic fields on the boundary of the electrodes are well-defined and therefore, the electrostatic forces are controllable near the boundaries.

In a further embodiment, preferably, said clamping electrode comprises an electric field attenuator that is configured in a configuration complementary to the protrusion configuration. Said electric field attenuator may comprise a dielectric layer and/or a ground layer. In this way, the electrostatic force that is developed between the substrate and the substrate holder is attenuated in between the protrusions in respect to the electric forces that are present between protrusions and the backside of the substrate. Correspondingly, the degree of bending in between the protrusions can be lowered significantly.

Embodiments of the invention will now be described, by way of example only, with reference to the accompanying schematic drawings in which corresponding reference symbols indicate corresponding parts, and in which:

Figure 1 depicts a lithographic projection apparatus according to an embodiment of the invention;
Figure 2 depicts a schematic plan view of a substrate holder according to the invention;
Figure 3 depicts a schematic partial view of the substrate of Figure 2 along the line I-I;
Figure 4 depicts a detailed cross-sectional view of another embodiment of a substrate holder according to the invention; and

Figure 5 depicts a detailed cross-sectional view of a third embodiment of a substrate holder according to the invention.

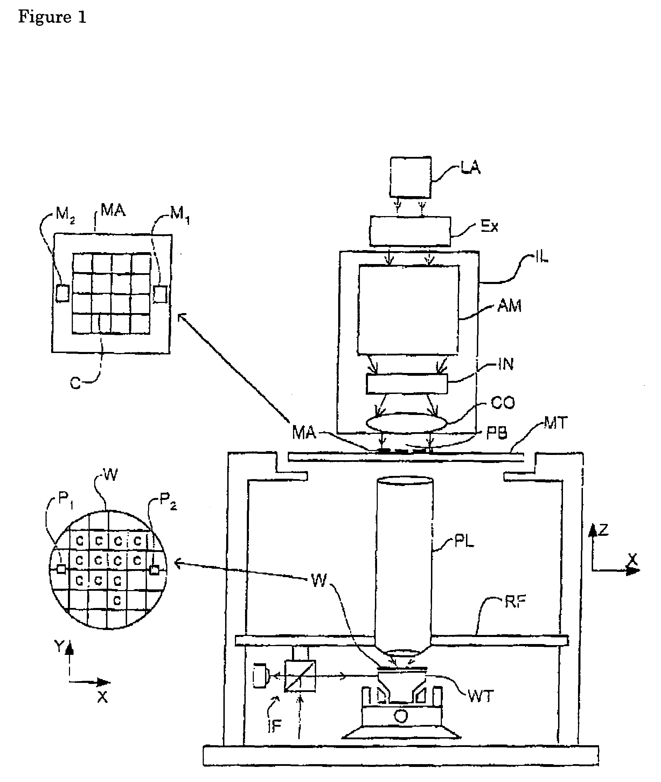

Figure 1 schematically depicts a lithographic projection apparatus according to a particular embodiment of the invention. The apparatus comprises:

- a radiation system Ex, IL, for supplying a projection beam PB of radiation (e.g. light in the deep ultraviolet region). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resistcoated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning devices, such as a programmable mirror array of a type as referred to above.

The source LA (e.g. an excimer laser source) produces a beam of radiation. This beam is fed into an Illumination system (illuminator) IL, either directly or after having traversed conditioning means, such as a beam expander Ex, for example. The illuminator IL may comprise adjusting means AM for setting the outer and/or inner radial extent (commonly referred to as s-outer and s-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed $V = Mv$, in which M is the magnification of the lens PL (typically, $M = 1/4$ or $1/5$). In this manner, a relatively large target portion C can be exposed, without having to compromise on resolution.

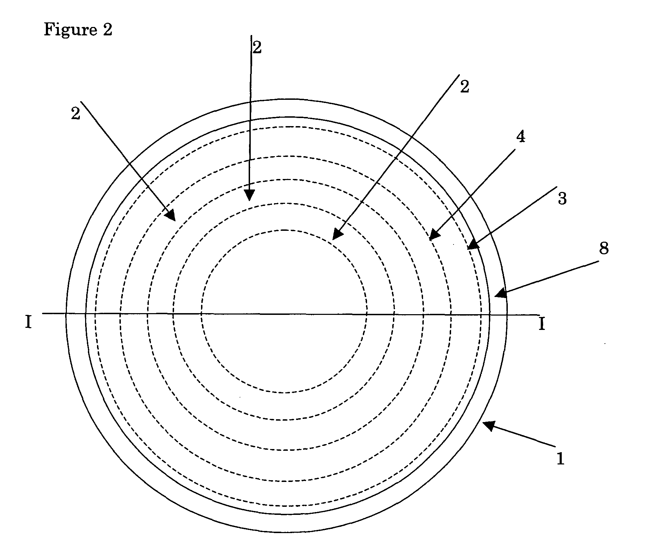

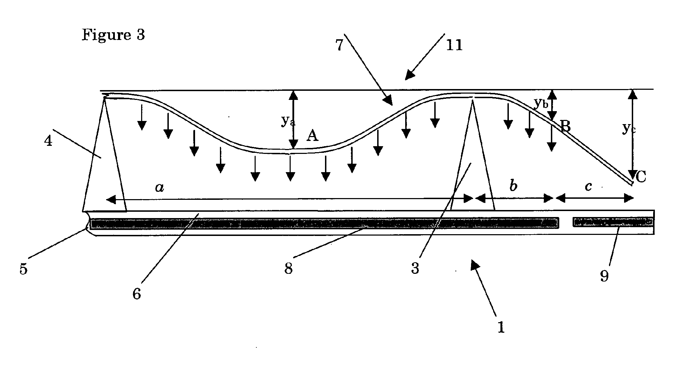

In Figure 2, a schematic plan view is illustrated of a substrate holder 1 according to the invention. In the figure, by the dotted lines, a plurality of protrusions 2 is pictured, the protrusions 2 being oriented in substantially concentric circles. These protrusions have a general diameter of 0.5 mm and are located generally at a distance of 3 mm away from each other and thereby form a bed of supporting members that support the substrate. By reference numerals 3 and 4, outermost circles of protrusions are referenced, having a mutual separation of distance a (see fig. 3). Furthermore, by reference numeral 8 is indicated an electrode that extends beyond the peripheral supporting edge. In this respect it is noted, that the peripheral supporting edge may be in the form of a wall having a contour that generally follows the contour of the substrate and which provides, when the substrate contacts the substrate holder 1, a gas-tight environment. Otherwise, the peripheral supporting edge 3 may comprise a plurality of mutually separated protrusions, hence forming an outermost circle of protrusions. In this setup a (not shown) sealing edge may be present that does not support the substrate but substantially prevents the backfill gas from leaking out.

Figure 3 is a schematic side view along the lines I-I of Figure 2. In this figure, outermost protrusion 3 and last but one outermost protrusion 4 are illustrated in a schematic way, outermost protrusion 3 thus forming a peripheral supporting edge. In the figure, the substrate holder 1 and substrate 7 extend towards the left hand side of the figure, schematically indicated by curved line 5. The protrusions 3 and 4 are supported by a base plate 6. The base plate is usually made of an electric isolator, such materials are known in the art (ULE (brandname of Corning) and sapphire). The protrusions, of which protrusions 3, 4 are shown, define a protrusion configuration for providing a substantially flat plane of support. In this way, a substantially flat substrate 7 is supported. In practice, the outermost protrusion 4 may be of a surrounding wall type, whereas the inner protrusions are usually cylindrical in form, so that a peripheral supporting edge surrounds the inner protrusions. In this way, for an electrostatic clamp, a gas-tight confinement may be rendered, wherein a backfill gas is confined by the backside of substrate 7, peripheral supporting edge 3 and base plate 6.

Also schematically, a clamping electrode 8 is illustrated that is embedded in the base plate that extends beyond the peripheral supporting edge 3. In this respect, the term buried is used, since as a general rule, the electrode 8 is covered by insulating material. Here, since the clamping electrode 8 extends beyond said last supporting edge of the substrate holder, in a controllable way, the clamping pressure near the boundaries of the substrate can be varied. Thus, depending on the size of the substrate in relation to the size of the support defined by the protrusion configuration, the electrode 8 can be extended outside the peripheral edge 3 in order to provide an optimum downward torsion moment for the substrate 7 near the edges. Ground electrode 9 extends around the clamping electrode 8 and peripheral supporting edge 3. Hereby, the electrostatic fields on the boundary of the electrodes 8 and 9 are well-defined near the boundaries.

By $a$ is indicated the distance between two protrusions 3, 4. By $b$ is indicated a distance of extension that is covered by an electrode 8 that extends beyond the peripheral supporting edge 3. By c is indicated an optional extra overhanging distance of the substrate between an outer edge of the clamping electrode 8 and the edge of the substrate 10, in addition to the overhang that is covered by clamping distance $b$.

From one-dimensional beam theory, the torsion moments near supporting edge 3 can be calculated as counterclock-wise torsion moment $M_a$ (clamped beam configuration), and clock-wise torsion moment $M_b$ (cantilevered beam configuration).

$$\left.\begin{array}{l} M_a = \dfrac{\Delta p a^2}{12} \quad with \quad \theta_a = 0 \\[2mm] M_b = \dfrac{\Delta p b^2}{2} \quad with \quad \theta_a = 0 \end{array}\right\} \quad M_a = M_b \longrightarrow b = 0.4a$$

$$\text{Equation 1}$$

In Equation 1, $\Delta p$ is the clamping pressure exerted by electrode 8, $a$ is the distance between outermost supporting edge 3 and last but one outermost protrusion 4, $b$ is the clamping distance and $\theta a$ is the counterclockwise rotation of the substrate near supporting edge 3. From the equation it is apparent, that for an unrotated configuration, the clamping distance should be extended over 0.4 times the supporting distance $a$ between the supporting protrusions. Furthermore, when the degree of unclamped overlap of the substrate indicated by c in Figure 3 is large in comparison with the supporting distance (in the order of ten times or larger), the substrate near the boundary tends to run out of the optimum dept of focus plane, substantially located at the plane of support formed by protrusions 3 and 4. By varying the clamping distance $b$ in relation to the degree of overhang c of the wafer, an optimum depth of focus for all areas on the substrate can be provided, where, depending on the magnitude of distance $c$, distance $b$ can be chosen smaller or larger.

Practical values of $c$ range between 0 and 10 times the supporting distance $a$, where values of $b$ range between 0.1 and 0.7 times the supporting distance $a$.
The table below shows the results for five load cases:

   1. the optimum distance b when the rotation of the substrate at the last supporting edge 3 is zero.

2. the optimum distance b for equal deflection at the substrate edge 10 and the substrate between the supporting protrusions, for a "small" substrate extension ($b+c=2a$)

3. the optimum distance b for equal deflection at the substrate edge 10 and the substrate between the supporting protrusions, for a "large" substrate extension ($b+c=10a$)

4. the optimum distance b for a maximum upward deflection of the wafer edge of 160 nm

5. the optimum b for a maximum upward downward of the wafer edge of 160 nm.

| | Effective clamp extension $b/a$ | Substrate edge extension $(b+c)/a$ | Total substrate deflection $y_{tot}$ at location: | | | Bending load from clamp extension $Mb/M$ | Design target |
|---|---|---|---|---|---|---|---|
| | | | left of last burl A | effective edge of clamp B | edge of wafer C | | |
| 1 | 0.408 | 2 | 2.46 | 3.26 | 20 | 1 | $y_b = y_a$ |
| 2 | 0.353 | 2 | 3.19 | 0.07 | 3.27 | 0.74 | $y_c = y_a$, small $c$ |
| 4 | 0.342 | 10 | 3.33 | -0.40 | 3.34 | 0.70 | $y_c = y_a$, large $c$ |
| 3 | 0.160 | 10 | 4.92 | -2.58 | -160 | 0.15 | $y_c >= -160$ nm, all $c$'s |
| 5 | 0.680 | 2 | -2.71 | 48 | 160 | 2.77 | $y_c <= 160$ nm, all $c$'s |

The column $M_b/M$ shows the variation in bending moment in the wafer just outside the last supporting edges for these designs. A range of about 0.1 to 3 is seen to envelop all optimum designs. Here, $M_b$ is the actual bending moment that the electro-static clamp applies to the wafer just outside the last protrusion. $M$ is a reference moment defined from the average constant electro-static clamp load and the protrusion pitch. Further, in the table, ya, yb, yc, denote the vertical substrate deflection from a flat reference plane that is parallel to the plane of support 11 defined by protrusions 2, near positions A, B and C, indicated in Figure 3.

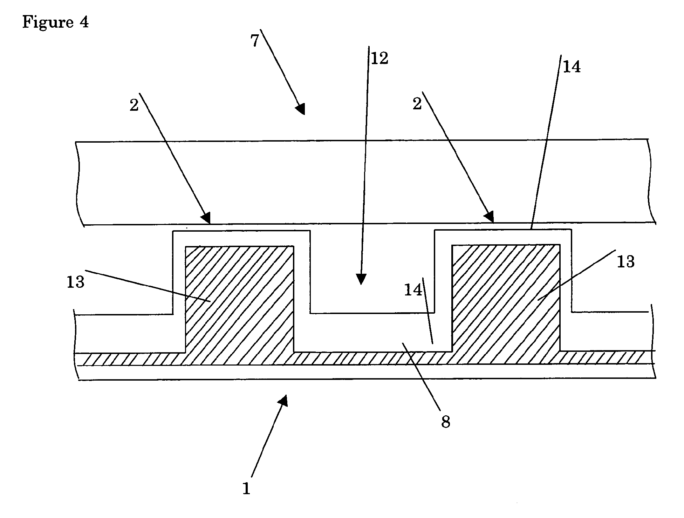

Figure 4 depicts a detailed cross-sectional view of another embodiment of a substrate holder according to the invention. In this embodiment, the deflection effects of electrostatic clamping are further mitigated by introducing an electric field attenuator that is configured in a configuration substantially complementary to the protrusion configuration. More specifically, Figure 4 shows a substrate holder 1 comprising protrusions 2, wherein the distance between the electrode 8 and the substrate 7 in the areas between the protrusions 2 is enlarged. Hence in the clamping electrode 8 recesses 12 are formed in between two neighboring protrusions 2, so that the electrostatic forces are reduced inversely proportional to said distance. Furthermore, in this embodiment, the electrode 8 is formed to have upstanding elements 13, protruding into protrusions 2, thus enlarging the electrostatic forces exerted on protrusions 2 in the direct supporting area of the protrusions. Since the electrostatic pressure in the unsupported areas between the protrusions 2 is substantially lowered, deflection will be less and thereby the focus error and overlay errors of a photolithographic illumination process will be reduced. Typical dimensions are a protrusion height of 5 μm, a surface roughness of 30 nm and an applied electrostatic load of 3 kV. In such a configuration, assuming that the electrostatic clamp is covered by a dielectric layer 14 of at least 20 μm having a dielectrical constant of 4 F/m and of 300 μm in the areas in between the protrusions, no gap voltages of more than 350 V occur throughout the substrate holder, thus preventing breakthrough. The applied voltage gives rise to a total estimated clamping pressure of 16 bar on the protrusions and 0.06 bar in between the protrusions.

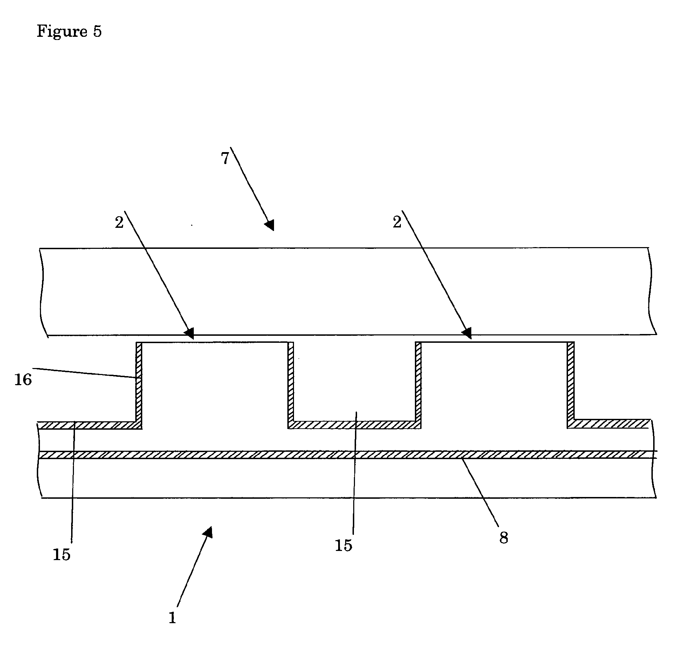

Figure 5 depicts a detailed cross-sectional view of yet another embodiment of a substrate holder according to the invention. In this embodiment, the deflection effects of electrostatic clamping are mitigated by introducing an ground layer 15 shielding the electrostatic fields in between the protrusions. The ground layer 15 can be a cover layer, but can also be buried in the substrate holder 1. In Figure 5, a configuration is depicted where side walls 16 of the protrusions are also covered by the ground layer 15. This offers an additional benefit that the substrate 7 is grounded. In addition, such a substrate holder may be manufactured quite easily after covering a substrate holder by a metal layer, the protrusion tops may be cleared and smoothed by a polishing process or the like.

The skilled artisan will appreciate that, in the context of such alternative applications, any use of the terms "reticle" or "wafer" or "substrate" in this text should be considered as being replaced by the more general terms as any article to be placed in the beam path. Such article may encompass patterning devices, the patterning device serving to impart the projection beam with a pattern in its cross-section or a substrate to be patterned by a patterned beam onto a target portion of the substrate. In addition the following definitions are given to illustrate general and specific contexts of certain concepts that are used in this text. The term "patterning device" as here employed should be broadly interpreted as referring to devices that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning devices include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning devices can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

Lithographic projection apparatus can be used, for example, in the manufacture of integrated circuits (ICs). In such a case, the patterning device may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

Further, the lithographic apparatus may be of a type having two or more wafer tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid crystal display panels, thin film magnetic heads, etc. In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Whilst specific embodiments of the invention have been described above, it will be appreciated that the invention may be practiced otherwise than as described. For instance, where the examples describe the substrate holder as a wafer table, for holding a substrate to be patterned by a patterned beam onto a target portion of the substrate, in some embodiments (particularly, in embodiments using a reflective mask) , also, the substrate holder may be a support for supporting patterning devices, the patterning devices serving to impart the projection beam with a pattern in its cross-section. The description is not intended to limit the invention.

## Claims

1. A lithographic projection apparatus comprising:

   - a radiation system for providing a projection beam of radiation; and
   - a substrate holder for supporting a substrate to be placed in a beam path of said projection beam, comprising a plurality of protrusions defining a protrusion configuration for providing a substantially flat plane of support for supporting a substantially flat substrate, the substrate holder comprising at least one clamping electrode for generating an electric field, for clamping the substrate against the substrate holder by said electric field; the substrate holder further comprising a peripheral supporting edge arranged to contact a substrate;

   **characterized in that**

   - said at least one electrode extends beyond said peripheral supporting edge for providing a torsion load to level the substrate near the edges of the substrate.

2. A lithographic projection apparatus according to claim 1, wherein said electrode extension generates a torsion load that ranges from 0.1 and 3 times a reference torsion load defined by $M = \frac{1}{12} \Delta p a^2$, wherein $\Delta p$ is an applied clamping pressure and $a$ is an average distance between two protrusions.

3. A lithographic projection apparatus according to claim 2, wherein said protrusion configuration is arranged in a series of concentric circles, and wherein said electrode extension satisfies the relationship of $0.3 < b/a < 0.6$, wherein $b$ is the distance of the electrode extension and $a$ the mutual separation between two concentric circles nearest the peripheral supporting edge.

4. A lithographic projection apparatus according to any of the preceding claims, **characterized in that** said substrate holder comprises a ground electrode extending along the peripheral supporting edge.

5. A lithographic projection apparatus according to claim any of the preceding claims, **characterized in that** said clamping electrode comprises an electric field attenuator that is configured to provide electric field attenuation substantially complementary to the protrusion configuration for concentrating the electric field pressure close to the protrusions.

6. A lithographic projection apparatus according to claim 5, wherein said electric field attenuator comprises a dielectric layer having a dielectric constant of 4 F/m of at least 200 $\mu$m and/or a ground layer.

7. A lithographic projection apparatus according to any of claims 5-6 claim 6, wherein said clamping electrode is recessed in between two neighbouring protrusions.

8. A lithographic projection apparatus according to claims 5-7, wherein said clamping electrode protrudes into each of said protrusions.

9. A lithographic apparatus according to claim 8, wherein said clamping electrode is covered by a dielectric layer having a dielectric constant of 4 F/m, of at least 20 $\mu$m.

10. A lithographic projection apparatus according to any of the preceding claims, wherein said substrate holder is a support table for holding a substrate to be patterned by a patterned beam onto a target portion of the substrate.

11. A substrate holder for a lithographic projection apparatus according to any of the preceding claims, comprising a plurality of protrusions defining a protrusion configuration for providing a substantially flat plane of support for supporting a substantially flat substrate, at least one clamping electrode for generating an electric field, for clamping a substrate against the substrate holder by said electric field; and a peripheral supporting edge arranged to contact a substrate; **characterized in that**

   - said at least one electrode extends beyond said peripheral supporting edge for providing a torsion load to level the substrate near the edges of the substrate.

12. A lithographic projection apparatus comprising:

   - a radiation system for providing a projection beam of radiation; and
   - a substrate holder for supporting a substrate to be placed in a beam path of said projection beam, comprising a plurality of protrusions defining a protrusion configuration for providing a substantially flat plane of support for supporting a substantially flat substrate, the substrate holder comprising at least one clamping electrode for generating an electric field, for clamping the substrate against the substrate holder by said electric field; the substrate holder further comprising a peripheral supporting edge arranged to contact a substrate;

   **characterized in that**

   - said clamping electrode comprises an electric field attenuator that is configured to provide electric field attenuation substantially complementary to the protrusion configuration for concentrating the electric field pressure close to the protrusions.

13. A lithographic projection apparatus comprising:

   a radiation system for providing a projection beam of radiation; and
   - a patterning device holder for supporting a patterning device to be placed in a beam path of said projection beam, comprising a plurality of protrusions defining a protrusion configuration for providing a substantially flat plane of support for supporting a substantially backside of said patterning means, the substrate holder comprising at least one clamping electrode for generating an electric field, for clamping the substrate against the substrate holder by said electric field; the substrate holder further comprising a peripheral supporting edge arranged to contact a substrate;

   **characterized in that**

   - said at least one electrode extends beyond said peripheral supporting edge for providing a torsion load to level the substrate near the edges of the patterning device.

Figure 1

Figure 2

Figure 3

Figure 4

Figure 5